# EUROPÄISCHE PATENTSCHRIFT

(11) **EP 0 746 640 B1**
(45) Veröffentlichungstag und Bekanntmachung des Hinweises auf die Patenterteilung: **09.06.1999**
(21) Anmeldenummer: 95912124.5
(22) Anmeldetag: 23.02.1995
(51) Int. Cl.: C25D 21/06, C25D 3/02, C25D 21/18

(54) **VERFAHREN ZUR ELEKTROLYTISCHEN ABSCHEIDUNG VON METALLEN AUS ELEKTROLYTEN MIT PROZESSORGANIK**
METHOD OF ELECTROLYTICALLY DEPOSITING METALS FROM ELECTROLYTES CONTAINING ORGANIC ADDITIVES
PROCEDE DE DEPOT ELECTROLYTIQUE DE METAUX A PARTIR D'ELECTROLYTES CONTENANT DES ADDITIFS ORGANIQUES

(30) Priorität: 23.02.1994 DE 4405741
(43) Veröffentlichungstag der Anmeldung: 11.12.1996
(73) Patentinhaber: ATOTECH Deutschland GmbH, 10553 Berlin (DE)
(72) Erfinder: SCHNEIDER, Reinhard, D-90556 Cadolzburg (DE)
(74) Vertreter: Effert, Udo, Dipl.-Ing.
(86) Internationale Anmeldenummer: DE9500297
(87) Internationale Veröffentlichungsnummer: WO9523247

(56) Entgegenhaltungen:
- DD-A- 215 589
- DE-A- 2 729 387
- DE-A- 4 031 979
- DE-A- 4 137 377

## Beschreibung

Die Erfindung betrifft ein Verfahren zur elektrolytischen Abscheidung von Metallen unter Verwendung von löslichen oder unlöslichen Anoden.

Die physikalischen Eigenschaften des abgeschiedenen Metalles können durch Zugabe von Stoffen in den Elektrolyten in weiten Grenzen verändert werden. Große Verbreitung haben hierfür organische Zusatzstoffe, auch Prozeßorganik oder Additivverbindungen genannt, gefunden. Sie bestimmen zum Beispiel Eigenschaften der abgeschiedenen Schichten wie Glanz, Dehnung und Härte. In der Leiterplattentechnik ist diese Prozeßorganik als Glanzbildner und Einebner bekannt.

Während des Galvanisierens verbraucht sich die Prozeßorganik kontinuierlich in geringen Mengen. Dies geschieht in allen Bereichen der Galvanoanlage, das heißt an der Kathode, an der Anode und im gesamten Elektrolytvolumen. Die verbrauchte Menge der Prozeßorganik muß ergänzt werden, was in der Regel diskontinuierlich geschieht. Jedoch entstehen hierdurch vermehrt Zersetzungsprodukte und Ablagerungen, und zwar durch den abscheidungsbedingten Verbrauch der Prozeßorganik sowie durch die mindestens zeitweilig zu große Menge der im Elektrolyten befindlichen Organik.

Wegen der sehr aufwendigen analytischen Erfassung der Prozeßorganik im Elektrolyten werden zur Nachdosierung indirekte Größen herangezogen, wie zum Beispiel die umgesetzten Amperestunden des elektrolytischen Prozesses. Fehldosierungen können nicht ausgeschlossen werden. Die daraus resultierenden Qualitätsmängel der abgeschiedenen Schicht treten oft sehr spät zutage d. h. es können große Schäden entstehen. Ein Beispiel hierfür sind prozeßorganikbedingte Fehler bei Leiterplatten, wie Lochrandabrisse, die sich erst beim späteren Einlöten der Bauteile oder danach auswirken.

Die Zersetzungsprodukte der Prozeßorganik verteilen sich unkontrolliert im gesamten Elektrolyten der Galvanoanlage. Die Verteilung wird gefördert durch prozeßbedingte Elektrolytbewegungen und Lufteinblasungen in der elektrolytischen Zelle sowie durch den im allgemeinen weitverzweigten Elektrolytkreislauf durch Nebenabteile und Partikelfilter. Diese Filter sind nicht in der Lage, die Zersetzungsprodukte abzutrennen. Die Zersetzungsprodukte sind analytisch nur mit großem Aufwand nachweisbar. Ihre Wirkung auf das Behandlungsgut in der elektrolytischen Zelle ist wegen der Vielfalt der beteiligten Stoffe und wegen der unterschiedlichen Konzentrationen nicht vorhersehbar. Durch die notwendige fortlaufende Ergänzung der verbrauchten Prozeßorganik nimmt auch die Konzentration der Zersetzungsprodukte im Elektrolyten zu. Versuche, dieser schädlichen Anreicherung durch Filterung zu begegnen, haben nur beschränkten Erfolg. Durch die weitläufige Verteilung der Prozeßorganik und ihrer Zersetzungsprodukte in der gesamten Galvanoanlage kann nicht verhindert werden, daß das Behandlungsgut unregelmäßigen Konzentrationen ausgesetzt wird. So schwankt im Bereich des Behandlungsgutes sowohl die dosierungsbedingte Konzentration der Prozeßorganik als auch die Menge der Zersetzungsprodukte. Die Folge hiervon ist, daß die Qualität der auf dem Behandlungsgut abgeschiedenen Metallschicht unkontrollierten Schwankungen unterliegt. So wird zum Beispiel beim Galvanisieren von Leiterplatten die sporadische Bildung von sogenannten Pickeln beobachtet, die sich an Ablagerungsstellen der Zersetzungsprodukte bilden. Behandlungsgut mit diesen punktförmigen Schichtdickenerhöhungen ist im allgemeinen Ausschuß. Desgleichen führt auch eine Griesbildung der abgeschiedenen Schicht, die zeitweise beobachtet wird, zum Ausschuß. Auch die Bruchelongation der Kupferschichten von Leiterplatten nimmt mit fortschreitender Standzeit eines elektrolytischen Bades ab, obwohl die analytisch feststellbare Konzentration der Prozeßorganik in den vorgegebenen Grenzen liegt. Zur Vermeidung einer unzulässigen Ansammlung von Verunreinigungen im Elektrolyten wird dieser kontinuierlich im Kreislauf durch Filter geführt. Verbreitet sind Kerzenfilter, die Partikel bis unterhalb von 0,2 µm abtrennen können. Die organischen Zersetzungsprodukte passieren derartige Filter in der Regel ungehindert. Desgleichen auch die unverbrauchte Prozeßorganik. Der Rücklauf des Filterkreislaufes in den Kathodenraum wird zur Anströmung des Elektrolyten an das Behandlungsgut genutzt.

Werden die zulässigen Grenzen der physikalischen Eigenschaften der abgeschiedenen Schichten unterschritten, obwohl die Konzentration der Prozeßorganik ausreichend groß ist, so muß der Elektrolyt gereinigt werden. In einer neuen Galvanoanlage kann bei einem neu angesetzten Elektrolyten dieser Zeitpunkt, abhängig von der Stromdichte, schon nach etwa drei Monaten erreicht werden, insbesondere dann, wenn an die Qualität der galvanischen Schicht hohe Anforderungen gestellt werden. Dies ist z. B. in der Leiterplattentechnik der Fall. Weitere Reinigungen des Elektrolyten und der Galvanoanlage werden danach in kürzeren Zeitabständen nötig. Ursache hierfür ist die Tatsache, daß es nicht gelingt, die Zersetzungsprodukte der Prozeßorganik, die sich nicht nur im Elektrolyten befinden, sondern sich auch an allen Wandungen, Rohren, Anoden und weiteren Badeinbauten, Aggregaten und Geräten ablagern, vollständig zu entfernen.

Die Reinigung des Elektrolyten von organischen Abbauprodukten erfolgt durch eine Aktivkohlebehandlung sowie durch Spülungen aller Behälter und Oberflächen, die mit dem Elektrolyten in Berührung kamen. Hierzu sind teilweise auch toxische Lösungsmittel erforderlich. Zum Nachteil der unvollständigen Reinigung kommt hinzu, daß der Galvanisierbetrieb für etwa einen Tag unterbrochen werden muß. Ferner muß ein Teil des Elektrolyten zusammen mit der Aktivkohle kostenaufwendig entsorgt werden.

In DE 27 29 387 Al ist ein Verfahren zur kontinuierlichen Aufbereitung eines galvanischen Nickelbades beschrieben, um die mit der Zersetzung von Badadditiven verbundenen Probleme zu vermeiden. Bei dem Verfahren wird ständig ein Teil aus dem Nickelbad entnommen und davon eine Teilmenge nach Verdünnung und vor der Rückführung in das Bad über einen Aktivkohlefilter geleitet.

Bei Verwendung von unlöslichen Anoden muß der Metallgehalt in der elektrolytischen Zelle entsprechend der Metallabscheidung fortlaufend ergänzt werden. Hierzu eignen sich Metallsalze, die dem Elektrolyten zugegeben werden. Vorteilhafter kann dies mit einem Redoxmittel als Zugabe in den Elektrolyten geschehen. Hierbei handelt es sich um einen reversibel elektrochemisch umsetzbaren Stoff. Ein derartiges Verfahren beschreibt die Patentschrift DD 215 589 Al. An den Anoden einer elektrolytischen Zelle oxidiert der Zusatzstoff. Diese oxidierte Stufe des Redoxmittels löst in einem Regenerierraum außenstromlos das elektrolytisch abzuscheidende Metall auf. Dabei wird der Zusatzstoff wieder in den Ausgangszustand reduziert. Die oxidierte Stufe greift eine im Elektrolyten befindliche Prozeßorganik sehr intensiv an, nicht jedoch die reduzierte Stufe. Ferner verringert die Anwesenheit der oxidierten Stufe des Redoxmittels an der Kathode die kathodische Stromausbeute auf unwirtschaftliche Werte.

Dieses Verfahren funktioniert somit nur bei solchen elektrolytischen Prozessen zufriedenstellend, die ohne Prozeßorganik auskommen. Dies ist zum Beispiel bei einer Mattverkupferung der Fall. Müssen aber die abgeschiedenen metallischen Schichten bestimmte physikalische Eigenschaften aufweisen, die nur durch die Zugabe von Prozeßorganik in den Elektrolyten erreichbar sind, so ist das zuvor beschriebene Verfahren ungeeignet. Ursache hierfür ist das Vorhandensein der die Prozeßorganik zerstörenden oxidierten Stufe des Redoxmittels in der gesamten Galvanoanlage. Desgleichen ist bei diesem Galvanisierverfahren auch die Prozeßorganik im Elektrolyten der gesamten Galvanoanlage verteilt. Die Folge sind eine sehr schnelle Zersetzung der Prozeßorganik durch die oxidierte Stufe des Redoxmittels und eine dadurch bedingte schnelle Anreicherung an Zersetzungsprodukten.

Der Erfindung liegt von daher das Problem zugrunde, ein Verfahren zur elektrolytischen Metallabscheidung aus Elektrolyten, die organische Zusätze enthalten, zu finden, die einen kontinuierlichen Betrieb bei gleichbleibender Qualität der abgeschiedenen Schicht unter Bedingungen ermöglichen, die umweltfreundlich und kostengünstig sind. Außerdem soll die Ergänzung der Badadditive ohne komplizierte Prozeßanalytik möglich sein. Das Verfahren soll die Verwendung von löslichen und unlöslichen Anoden ermöglichen.

Das Problem wird gelöst durch ein Verfahren gemäß Anspruch 1. Bevorzugte Ausführungsformen der Erfindung sind in den Unteransprüchen angegeben.

Die Problemlösung umfaßt ein Verfahren zur elektrolytischen Abscheidung von Metallen bestimmter physikalischer Eigenschaften auf den Oberflächen von Behandlungsgut.

Das Verfahren ist durch folgende Merkmale gekennzeichnet:
- Eine zur Steuerung der physikalischen Eigenschaften der Metalle Additivverbindungen (Prozeßorganik) enthaltende, durch Flüssigkeitsströmung in Bewegung versetzte und im Kreislauf geführte Behandlungslösung wird mit dem Behandlungsgut und Anoden in Kontakt gebracht,
- die Additivverbindungen werden der Behandlungslösung an einer Stelle in der Anlage zugegeben, wo sie durch Strömung schnell an das Behandlungsgut gelangen können, d.h. dort, wo sie prozeßrelevant sind,
- die Behandlungslösung wird im Abscheidungsraum strömungstechnisch so geführt, daß sie sich mit Lösungen aus dem Bereich der Anoden nicht vermischen, und/oder
- die in der Nähe der Anoden (Anodenraum) befindliche Lösung und die in der Nähe des Behandlungsgutes (Kathodenraum) befindliche Lösung werden durch ionendurchlässige Mittel so voneinander getrennt, daß sich diese Lösungen nicht vermischen,
- entstandene Zersetzungsprodukte und unverbrauchte Additivverbindungen in der Lösung werden mittels Filter aus der im Anodenraum befindlichen und/oder vom Anodenraum und/oder vom Kathodenraum wegströmenden Behandlungslösung entfernt und
- zu der zum Kathodenraum strömenden und keine Additivverbindungen enthaltenden Behandlungslösung werden ständig die der in der Behandlungslösung einzustellenden Konzentration entsprechende Menge der Additivverbindungen zugegeben.

Unter Behandlungslösung wird im wesentlichen die ständig im Kreislauf geführte, gegebenenfalls mit Additivresten und Zersetzungsprodukten beladene Lösung verstanden, die der Behandlung des Behandlungsgutes dient. Ansonsten wird im wesentlichen nur der Begriff Lösung verwendet, auch zur Kennzeichnung einer Lösung, die eine zur Behandlungslösung unterschiedliche Zusammensetzung hat.

Es ist erfindungsgemäß auch möglich, der für die Anodenräume bestimmten Lösung Additive zuzusetzen, die Einfluß auf die Anodenwirkung, deren Löslichkeitsverhalten sowie die Gasbildung an der Anode haben, um negativen Betriebszuständen entgegenzuwirken. Auch diese teils überschüssigen Additive und gegebenenfalls weitere Zersetzungsprodukte, Anodenschlamm und ähnliches werden mit entsprechend ausgewählten und bestückten Filtern im Kreislauf aus der Lösung wieder ausgefiltert.

Eine Weiterbildung der Erfindung besteht darin, die Additivverbindungen aus der in einem mit dem Kathodenraum verbundenen Kathodenstromkreislauf befindlichen Behandlungslösung und aus der in einem mit dem Anodenraum verbundenen und vom Kathodenstromkreislauf getrennten Anodenstromkreislauf befindlichen Behandlungslösung vermittels den einzelnen Kreisläufen zugeordnete Filter zu entfernen.

Die Konzentration der Additivverbindungen in der Behandlungslösung kann durch ständiges Zugeben der Verbindungen in der mindestens dem fortlaufenden Verbrauch der Additivverbindungen entsprechenden Menge aufrechterhalten werden. Werden die Additivverbindungen in der zum Behandlungsgut geförderten Behandlungslösung durch Filter vollständig entfernt, so kann die Ergänzungsmenge zur Aufrechterhaltung der vorgegebenen Konzentration der Additivverbindungen im Kathodenraum rechnerisch leicht ermittelt werden. Infolge nahezu fehlender Additivverbindungen in der Behandlungslösung an der Stelle, wo die Verbindungen der Lösung zugegeben werden, kann die Menge der nachzudosierenden Additivverbindungen im wesentlichen vom Volumen der im Kreislauf geführten Behandlungslösung abgeleitet und muß nicht aus Analysenergebnissen ermittelt werden.

In einer weiteren Ausführungsform werden die Lösungen aus dem Kathoden-bzw. Anodenraum über separate Kreisläufe geführt und gefiltert. Beispielsweise können die Lösungen getrennt über Filter geleitet und danach gemeinsam in die einzelnen Räume wieder zurückgefördert werden.

In einer weiteren Ausführungsform wird die Behandlungslösung in einer seriellen Kreislaufführung vom Behandlungsgut über Filter zur Anode und von dort wieder zurück zum Behandlungsgut im Kreislauf geführt.

Als Filter werden beispielsweise Wickelkerzenfilter, Scheibenfilter, Anschwemmfilter, Schwerkraftabscheider, Aktivkohlefilter, Osmosefilter, Molekularsiebe und lonenaustauscher verwendet.

Die Additivverbindungen können auch durch zusätzliches Filtern mittels Aktivkohle in einen zusätzlichen Elektrolytbehälter, der zur Aufnahme der gefilterten Behandlungslösungen dient, entfernt werden. Damit die Aktivkohle nicht in die Lösung geschwemmt wird, ist sie in geeigneten Gefäßen, Beuteln oder Säcken untergebracht, die von der Lösung durchströmt werden.

Werden unlösliche Anoden zur elektrolytischen Abscheidung verwendet, so kann der durch die Abscheidung verursachte Verlust an Metallionen in der Behandlungslösung durch chemische Auflösung von Metallteilen mittels der Behandlungslösung zugegeber Verbindungen elektrochemisch reversibler Redoxsysteme kompensiert werden.

In diesem Falle ist es außerordentlich vorteilhaft, wenn die in einem separaten Regenerierraum befindlichen Metallteile eine so große wirksame Oberfläche aufweisen, daß praktisch alle dem Regenerierraum im Kreislauf zugeführten metalllösenden Verbindungen des Redoxsystems bei gleichzeitiger Auflösung der Metallteile chemisch reduziert werden.

Zur Durchführung des erfindungsgemäßen Verfahrens dient eine Vorrichtung, umfassend
- einen Abscheidungsraum, Anoden, eine Stromversorgung zur Polarisierung des Behandlungsgutes gegenüber den Anoden sowie Pumpen und Leitungen zur Förderung des Behandlungsmittels in der Vorrichtung,
- Mittel zur Strömungsführung der Behandlungslösung und/oder ionendurchlässige Mittel zur Vermeidung der Vermischung der in der Nähe der Anoden befindlichen Lösung und der in der Nähe des Behandlungsgutes befindlichen Lösung,
- Mittel zum Dosieren der Additivverbindungen, wobei diese in der Anlage so plaziert sind, daß die zudosierten Additivverbindungen durch Strömung schnell in die Nähe des Behandlungsgutes gelangen können,
- Filter zum Entfernen entstandener Zersetzungsprodukte und überschüssiger Additivverbindungen aus der im Kreislauf strömenden Behandlungslösung.

Nachfolgend wird das erfindungsgemäße Verfahren anhand einer Zeichnung erläutert. Im einzelnen sind dargestellt in
- Figur 1:: Schema einer Galvanoanlage;
- Figur 2:: Schema einer Galvanoanlage ohne Elektrolytbehälter;
- Figur 3:: Schema einer Galvanoanlage mit unlöslichen Anoden;
- Figur 4:: Schema einer Galvanoanlage mit unlöslichen Anoden für plattenförmiges Behandlungsgut

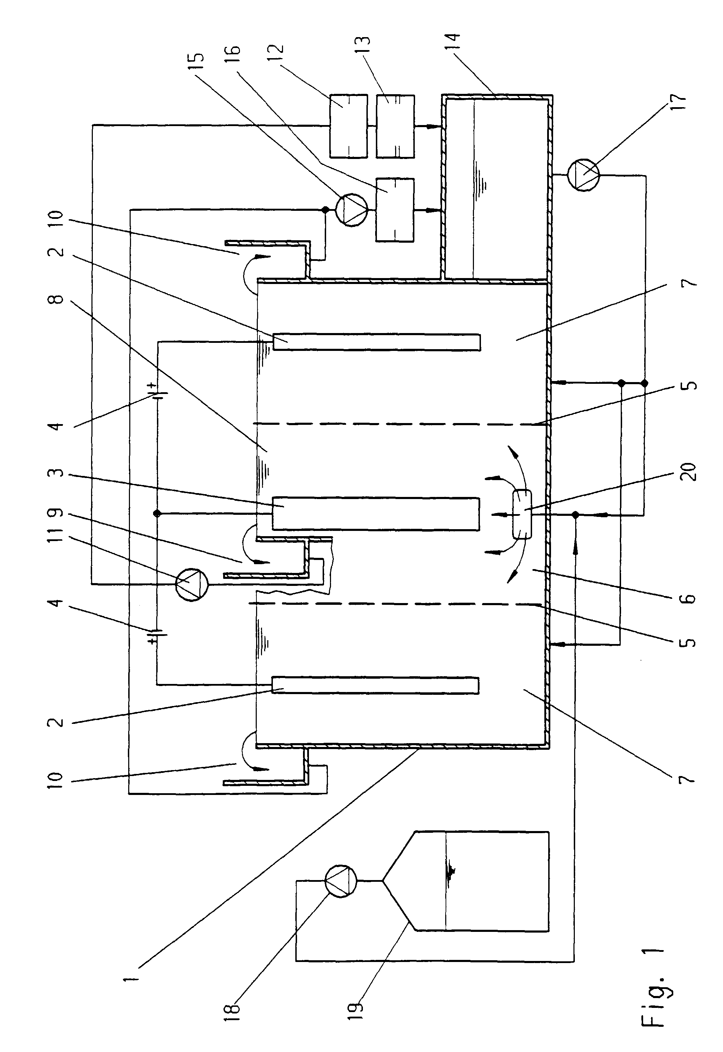

Die schematische Darstellung einer Galvanoanlage in Figur 1 zeigt einen Badbehälter 1 mit den Anoden 2 für die Vorder- und Rückseite des kathodischen Behandlungsgutes 3.

Das Bad wird mittels der Stromquellen 4 mit Strom versorgt. Der Badbehälter 1 ist durch Diaphragmen S in einen Kathodenraum 6 und in zwei Anodenräume 7 flüssigkeitsdicht, jedoch ionendurchlässig unterteilt. Die Behandlungslösung/ der Elektrolyt 8 im Kathodenraum 6 kann über einen hier als Überlauf dargestellten Ablauf 9 abfließen. Die Elektrolyten der Anodenräume 7 haben die Abläufe 10. Von der Pumpe 11 gefördert, gelangt der Elektrolyt des Kathodenraumes 6 in den Partikelfilter 12 und in den Aktivkohlefilter 13, danach in den Elektrolytbehälter 14. Desgleichen gelangt der Elektrolyt aus den Anodenräumen 7, von der Pumpe 15 gefördert, durch den Partikelfilter 16 in den Elektrolytbehälter 14. Eine weitere Pumpe 17 fördert den Elektrolyt wieder in den Kathodenraum 6 und in die Anodenräume 7 zurück via nicht dargestellter Mehrwegeventile. Dem Elektrolytstrom in den Kathodenraum 6 wird die Prozeßorganik zudosiert. Diese wird mittels einer Dosierpumpe 18 aus dem Vorratsbehälter 19 gefördert. Der Elektrolytstrom im Kathodenraum 6 wird durch das Rohr 20 verteilt.

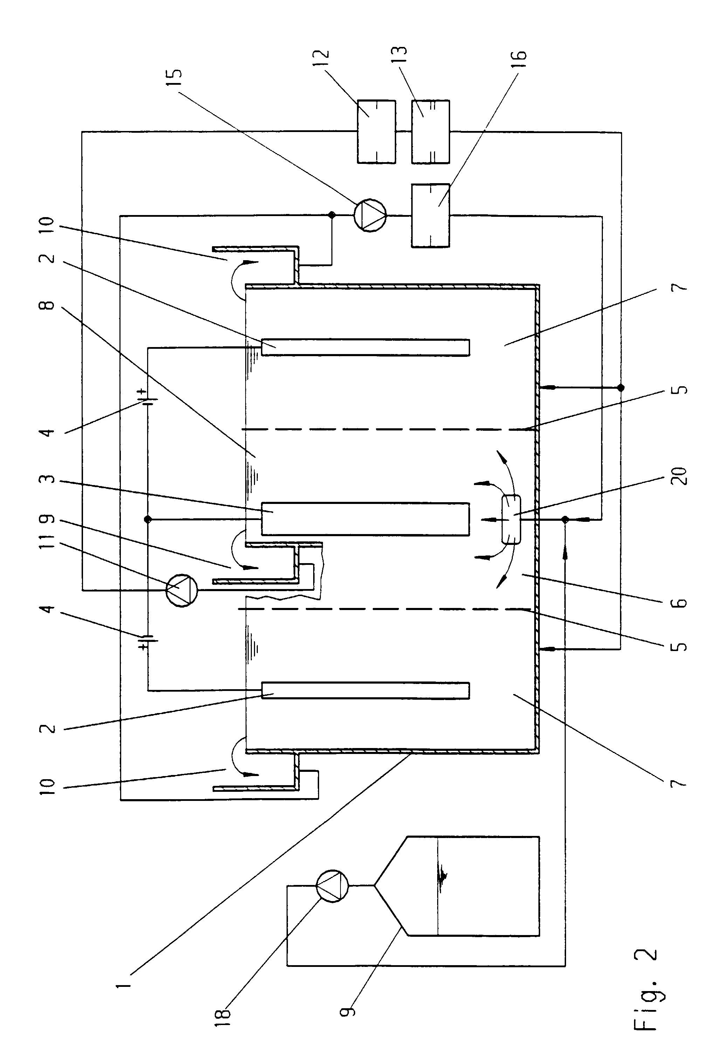

Die Figur 2 zeigt schematisch eine ähnliche Galvanoanlage wie Figur 1, jedoch ohne Elektrolytbehälter. Hier wird der Elektrolyt im Kreislauf geführt und zwar seriell vom Kathodenraum 6 durch die Filter 12 und 13 in die Anodenräume 7 und von dort durch das Filter 16 in den Kathodenraum 6 zurück. Darüber hinaus entspricht die Galvanoanlage in Figur 2 der Galvanoanlage in Figur 1.

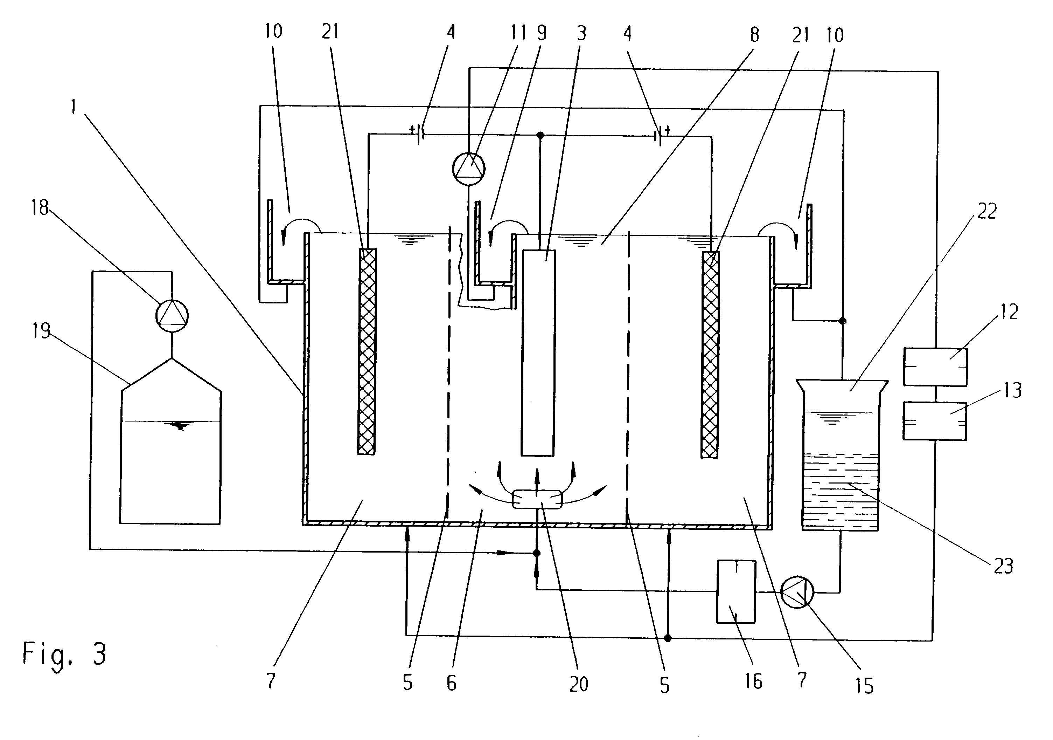

Die Figur 3 zeigt schematisch die Anwendung des erfindungsgemäßen Verfahrens unter Verwendung von unlöslichen Anoden 21 in einer dritten Ausführungsform der Galvanoanlage, dessen Elektrolyt in einem gesonderten Regenerierraum 22 mit dem elektrolytisch abzuscheidenden Metall angereichert wird. Der Regenerierraum 22 ist mit Metallstücken 23 befüllt. Dieses aufzulösende Metall ist elektrolytdurchlässig gelagert. Die Kreislaufführung des Elektrolyten entspricht den Abläufen, wie sie anhand der Figur 2 beschrieben wurden.

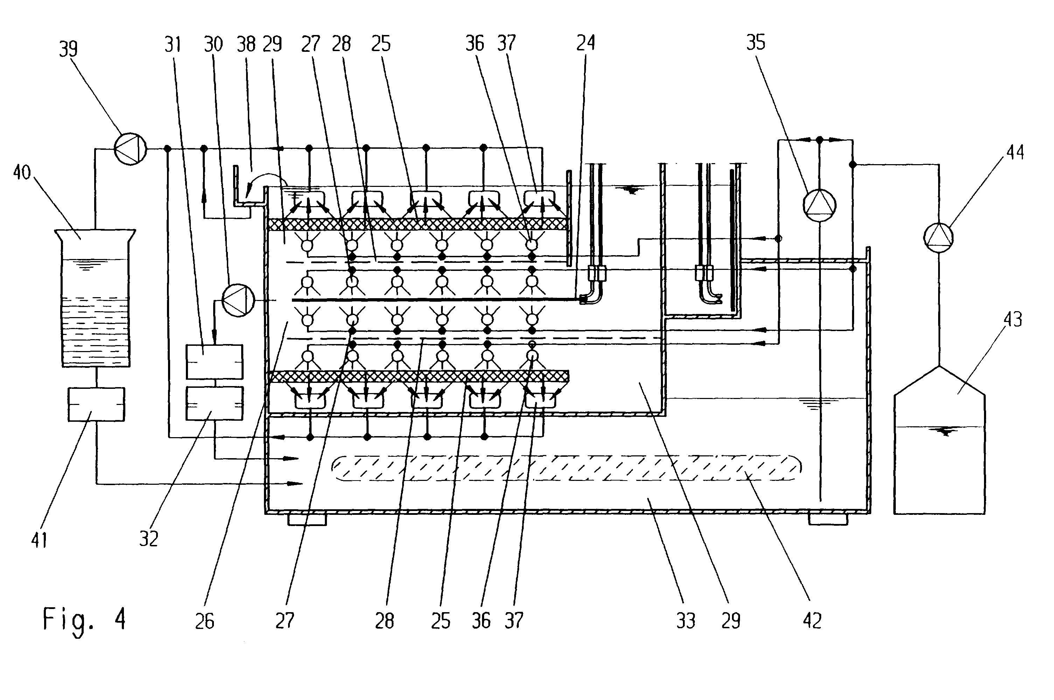

Figur 4 zeigt die prinzipiellen Abläufe des erfindungsgemäßen Verfahrens in einer Galvanoanlage für plattenförmiges Behandlungsgut 24 unter Verwendung von unlöslichen Anoden 25. Das Behandlungsgut 24 wird horizontal durch die Galvanoanlage transportiert. Es wird im Kathodenraum 26 mittels Flutrohren 27 mit Elektrolyt angeströmt. Dieser Elektrolyt ist wieder durch Diaphragmen 28 vom Elektrolyten des Anodenraumes 29 flüssigkeitsdicht, jedoch ionendurchlässig getrennt. Aus dem Kathodenraum 26 gelangt der im Kreislauf geführte Elektrolyt von der Pumpe 30 gefördert in einen Partikelfilter 31 und in einen Aktivkohlefilter 32 und von dort in den Elektrolytbehälter 33. Aus diesem Behälter fördert die Pumpe 35 den Elektrolyt in die Flutrohre 27 zur Kathode und in die Flutrohre 36 zu den unlöslichen Anoden 25. Durch Saugrohre 37 und über den Ablauf 38 gelangt der Elektrolyt von der Pumpe 39 gefördert in den Regenerierraum 40, der mit dem Metall, das aufgelöst werden soll, befüllt ist. Durch den anschließenden Partikelfilter 41 wird der mit Metallionen angereicherte Elektrolyt dem Elektrolytbehälter 33 wieder zugeführt. In diesem Behälter 33 kann zur Aufnahme von möglicherweise noch im Elektrolyten befindlicher Prozeßorganik Aktivkohle 42 in austauschbaren Beuteln oder Säcken gelagert sein. Die Prozeßorganik im Vorratsbehälter 43 wird von der Dosierpumpe 44 gefördert dem Elektrolyten beigemischt, der in den Kathodenraum 26 eingeleitet wird. Die in Figur 4 schematisch dargestellte Galvanoanlage kann auch mit löslichen Anoden betrieben werden. In diesem Falle entfällt der Regenerierraum 40.

Die Besonderheiten des in allen dargestellten Galvanoanlagen anwendbaren erfindungsgemäßen Verfahrens werden nachfolgend weiter erläutert.

Der für die Prozeßorganik prozeßrelevante Bereich des Elektrolyten wird durch ein oder mehrere Diaphragmen räumlich klein gehalten. Beim Galvanisieren ist dieser Bereich in der Regel nur der Kathodenraum. Hier befindet sich die Prozeßorganik in einer Konzentration, die nicht größer ist, als sie zur Erzielung von qualitativ einwandfreien metallischen Schichten nötig ist. Mindestens ein Diaphragma S teilt die elektrolytische Zelle der Figur 1 in zwei Elektrolytbereiche, nämlich in den Anodenraum 7 und in den Kathodenraum 6.

Der Elektrolyt des Kathodenraumes 6 wird mittels einer Pumpe 11 im Kreislauf geführt. Unmittelbar nach der elektrolytischen Zelle sind in den Figuren 1 bis 4 als Beispiel ein Partikelfilter 12 sowie ein Aktivkohlefilter 13 zur Entfernung der organischen Bestandteile des Elektrolyten angeordnet. Das Aktivkohlefilter ist so groß dimensioniert, daß praktisch die gesamte noch im Elektrolyten befindliche Prozeßorganik und ihre Zersetzungsprodukte kontinuierlich entfernt werden.

Bei hoher Schmutzfracht des Behandlungsgutes kann für den Kathodenraum ein zusätzlicher Elektrolytkreislauf durch ein weiteres Partikelfilter geführt werden. Desgleichen kann bei zum Beispiel starkem Anodenschlammanfall ein zusätzlicher Filterkreislauf mit separatem Filter für den Anodenraum eingerichtet werden. Dies hat den Vorteil, daß die Elektrolytumlaufmenge des Kreislaufes durch das Partikelfilter 12 und durch das Aktivkohlefilter 13 dem Prozeßorganikverbrauch der elektrolytischen Zelle genauer angepaßt werden kann.

Für die Filter 12, 13, 16, 31, 32 können in der Praxis alle bekannten Mittel und Methoden zur Anwendung kommen, wie zum Beispiel Wickelkerzenfilter. Scheibenfilter, Anschwemmfilter, Schwerkraftabscheider, Molekularsiebe, Aktivkohlebehandlung, Osmosefilter, lonenaustauscher sowie weitere physikalisch oder chemisch wirkende Trenneinrichtungen. Ferner ist die Anwendung von elektrischen Potentialen zur Erzeugung von elektrischen und magnetischen Feldern in Filtern möglich.

Nach den Filtern gelangt der Elektrolyt in einer Galvanoanlage nach Figur 1 in einen Elektrolytbehälter 14 und erst von dort wieder in die elektrolytische Zelle. Der Elektrolyt im Elektrolytbehälter 14 ist erfindungsgemäß weitgehend frei von Prozeßorganik. Organikbedingte Zersetzungsprodukte können sich hier also nicht bilden. Damit entstehen auch keine der eingangs beschriebenen störenden Organikablagerungen. Eine weitere Pumpe 17 fördert den prozeßorganikfreien Elektrolyt in die elektrolytische Zelle zurück. Im allgemeinen muß nur der dem Kathodenraum zugeführte Elektrolyt mit neuer Organik durch kontinuierliche Dosierung angereichert werden. Zweckmäßig geschieht dies, bevor der Elektrolyt in den Kathodenraum 6 gelangt. In Ausnahmefällen kann auch dem Elektrolyt, der in den Anodenraum eingeleitet wird, eine spezifische Organik zudosiert werden. Die Restmenge wird im Elektrolytkreislauf nach der elektrolytischen Zelle ebenfalls wieder herausgefiltert. Hierzu können individuell auf die Organik abgestimmte Filter verwendet werden. Diese Situation ist in den Figuren nicht dargestellt. Vorteilhaft bei der Erfindung ist, daß diese Dosierungen immer von einer gleichen Konzentration der Prozeßorganik im Elektrolyten ausgehen können, nämlich von der Konzentration null. Das heißt, es entspricht praktisch einem Neuansatz des Elektrolyten. Hierfür sind die Dosiermengen der Prozeßorganik je Komponente pro Elektrolytvolumeneinheit bekannt und somit sehr genau und ohne großen technischen Aufwand zu ergänzen. Das permanente Nachdosieren stützt sich also nicht auf die Analyse der Prozeßorganik, was technisch sehr aufwendig ist, wie zum Beispiel die zyklische Voltametrie. Sporadische Kontrollen beschränken sich nur auf den Nachweis von Prozeßorganik in Bereichen, die erfindungsgemäß organikfrei sein sollen.

Die Nachdosierung der Prozeßorganik erfolgt kontinuierlich oder quasikontinuierlich so, daß sich in der elektrolytischen Zelle, und dort nur in den prozeßrelevanten Raum, gerade wieder die erforderliche Konzentration einstellt. Als Dosierort eignet sich eine Impfstelle im Rohrleitungssystem des Elektrolytkreislaufes in der Nähe der elektrolytischen Zelle. Der Verbrauch an Prozeßorganik ist auch volumenmäßig gering. Weil das Dosieren von größeren Volumina technisch einfacher ist, kann die Prozeßorganik so weit vorverdünnt werden, wie es die Ausschleppung des Elektrolyten aus der elektrolytischen Zelle durch das Behandlungsgut zuläßt. Zur Verdünnung werden geeignete Flüssigkeiten oder der Elektrolyt selbst herangezogen. Die kontinuierliche Dosierung dieser Prozeßorganik in die Impfstelle und ihre Durchmischung in der Rohrleitung gewährleistet ihre gleichmäßige Verteilung im prozeßrelevanten Raum der elektrolytischen Zelle.

In einer weiteren Galvanoanlage entsprechend der Figur 2 wird der Elektrolyt dem Kathodenraum 6 entnommen und nach der Filtrierung frei von Prozeßorganik in den Anodenraum 7 geleitet. Von dort wird er wieder in den Kathodenraum mittels der Pumpe 15 zurückgepumpt, wobei dieser Elektrolyt wie beschrieben mit Prozeßorganik durch Dosierung angereichert wird.

Auf die Verwendung von Diaphragmen zur Vermeidung einer Durchmischung der Elektrolyten der Anodenräume vom Elektrolyten des Kathodenraumes kann auch verzichtet werden. In diesem Falle ist die Strömungsführung der in die elektrolytische Zelle zurückgeleiteten Elektrolyten derart zu wählen, daß eine Durchmischung nicht stattfindet. Mit Hilfe von gezielt ausgerichteten Flutrohren im Bereich der theoretischen Raumtrennung ist dies realisierbar. In einer Galvanoanlage gemäß Figur 4 werden mit den Flutrohren 36 die Anoden 25, und mit den Flutrohren 27 wird die Kathode gezielt angeströmt. Bei ausreichender Elektrolytumlaufmenge und damit entsprechender Strömungsgeschwindigkeit kann das Diaphragma 28 entfallen.

Bei der Verwendung von unlöslichen Anoden kann der Metallgehalt im Elektrolyten mit Hilfe eines geeigneten Redoxmittels ergänzt werden. Es muß jedoch dafür gesorgt werden, daß die Prozeßorganik, die an der Kathode benötigt wird, nicht mit der oxidierten Stufe des Redoxmittels vermischt wird. Das erfindungsgemäße Verfahren löst genau diese Anforderung. Die Prozeßorganik befindet sich durch Diaphragmen 5, 28 getrennt nur im Kathodenraum 6, 26, der frei von der aggressiven oxidierten Stufe des Redoxmittels ist. Somit ist hier die Organik geschützt. Der Anodenraum 7, 29 und der sich daran anschließende Regenerierraum 22, 40 ist frei von Prozeßorganik, beinhaltet jedoch die oxidierte Stufe des Redoxmittels, die zur Auflösung des Metalles im Regenerierraum 22, 40 erforderlich ist.

Wenn zusätzlich durch Angebot einer genügend großen wirksamen Oberfläche des aufzulösenden Metalles im Regenerierraum 22, 40 alle hier im Elektrolyten befindlichen lonen der oxidierten Stufe des Redoxmittels reduziert werden, ist der vom Regenerierraum in den Kathodenraum zu fördernde Elektrolyt frei von aggressiven Stoffen, die dort die Prozeßorganik angreifen könnten. Die Erfindung erlaubt somit die Metallanreicherung des Elektrolyten mit Hilfe eines Redoxmittels.

Das erfindungsgemäße Verfahren gewährleistet ein dauerhaft hochqualitatives Abscheiden von metallischen Schichten aus Elektrolyten, die Zusätze von Prozeßorganik enthalten. Dabei ist die Verwendung von löslichen und unlöslichen Anoden möglich. Ferner stellt das Verfahren sicher, daß das Dosieren der qualitätsentscheidenden Prozeßorganik unter Bedingungen stattfindet, die auf einfache Ausgangszustände der Konzentrationen der Prozeßorganik zurückzuführen sind. Daraus resultiert eine technisch sehr einfache und reproduzierbare Prozeßführung. Eine aufwendige analytische Istwerterfassung der Prozeßorganik im Elektrolyten ist nicht erforderlich. Dies schließt ein, daß jede beliebige Prozeßorganik in jeder beliebigen, insbesondere minimalen Konzentration verwendet werden kann, ohne aufwendig und häufig den Elektrolyten analysieren zu müssen.

## Patentansprüche

1. Verfahren zur elektrolytischen Abscheidung von Metallen bestimmter physikalischer Eigenschaften auf den Oberflächen von Behandlungsgut mittels einer durch Flüssigkeitsströmung in Bewegung versetzten und im Kreislauf geführten Behandlungslösung, der zur Steuerung der physikalischen Eigenschaften der Metalle dienende Additivverbindungen zugegeben werden, bei dem
- die Lösung mit dem Behandlungsgut und Anoden in Kontakt gebracht wird,
- die in der Nähe der Anoden (Anodenraum) befindliche Lösung und die in der Nähe des Behandlungsgutes (Kathodenraum) befindliche Lösung durch ionendurchlässige Mittel so voneinander getrennt werden und/oder die Behandlungslösung in einem Abscheidungsraum so geführt wird, daß sich die in der Nähe der Anoden (Anodenraum) befindliche Lösung und die in der Nähe des Behandlungsgutes (Kathodenraum) befindliche Lösung nicht vermischen,
- die zur Steuerung der physikalischen Eigenschaften der Metalle dienenden Additivverbindungen der Behandlungslösung an einer Stelle im Kreislauf zugegeben werden, von der aus sie durch Strömung nur in den Kathodenraum gelangen können, wobei
- zu der zum Kathodenraum strömenden, keine Additivverbindungen enthaltenden Behandlungslösung ständig die der in der Behandlungslösung einzustellenden Konzentration entsprechende Menge der Additivverbindungen zugegeben wird, und
- entstandene Zersetzungsprodukte und unverbrauchte Additivverbindungen mittels Filter aus der im Anodenraum befindlichen und/oder vom Anodenraum und/oder vom Kathodenraum wegströmenden Lösung entfernt werden.

2. Verfahren nach Anspruch 1, dadurch gekennzeichnet, daß der dem Anodenraum zugeführten Behandlungslösung spezielle Additive zudosiert werden, deren Reste einschließlich im Anodenraum entstandener Zersetzungsprodukte aus der rückgeführten Lösung im Kreislauf mittels speziell auf die auszufilternden Bestandteile abgestimmter Filter ausgefiltert werden.

3. Verfahren nach einem der Ansprüche 1 oder 2, dadurch gekennzeichnet, daß die Additivverbindungen aus der in einem mit dem Kathodenraum verbundenen Kathodenstromkreislauf befindlichen Behandlungslösung und aus der in einem mit dem Anodenraum verbundenen und vom Kathodenstromkreislauf getrennten Anodenstromkreislauf befindlichen Behandlungslösung mittels den einzelnen Kreisläufen zugeordnete Filter entfernt werden.

4. Verfahren nach einem der vorstehenden Ansprüche, dadurch gekennzeichnet, daß die Menge der nachzudosierenden Additivverbindungen infolge von nahezu fehlenden Additivverbindungen in der Behandlungslösung an der Stelle, wo die Verbindungen der Lösung zugegeben werden, im wesentlichen vom Volumen der im Kreislauf geführten Behandlungslösung abgeleitet wird.

5. Verfahren nach einem der vorstehenden Ansprüche, dadurch gekennzeichnet, daß Filter, ausgewählt aus einer Gruppe, bestehend aus Wickelkerzenfiltern, Scheibenfiltern, Anschwemmfiltern, Schwerkraftabscheidern, Aktivkohlefiltern, Osmosefiltern, Molekularsieben und lonenaustauschern, verwendet werden.

6. Verfahren nach einem der vorstehenden Ansprüche, dadurch gekennzeichnet, daß die Lösung zunächst in einem ersten Partikelfilter und danach mittels Aktivkohle gefiltert wird.

7. Verfahren nach einem der vorstehenden Ansprüche, dadurch gekennzeichnet, daß die Behandlungslösung vom Behandlungsgut über Filter zur Anode und von dort wieder zurück zum Behandlungsgut im Kreislauf geführt wird.

8. Verfahren nach einem der Ansprüche 1 bis 6, dadurch gekennzeichnet, daß die Lösungen des Anodenraumes und des Kathodenraumes in separaten Kreisläufen geführt und gefiltert werden.

9. Verfahren nach einem der vorstehenden Ansprüche, dadurch gekennzeichnet, daß bei Verwendung unlöslicher Anoden ein durch elektrolytische Abscheidung von Metall verursachter Verlust an Metallionen in der Behandlungslösung durch chemische Auflösung von Metallteilen mittels der Behandlungslösung zugegebener Verbindungen elektrochemisch reversibler Redoxsysteme kompensiert wird.

10. Verfahren nach Anspruch 9, dadurch gekennzeichnet, daß die in einem separaten Regenerierraum (10) befindlichen Metallteile eine so große wirksame Oberfläche aufweisen, daß praktisch alle dem Regenerierraum im Kreislauf zugeführten metallösenden Verbindungen des Redoxsystems bei gleichzeitiger Auflösung der Metallteile chemisch reduziert werden.

## Claims

1. Method of electrolytically depositing metals of certain physical properties on the surfaces of treatment material by means of a treatment solution, which is set in motion by liquid flow and circulated, to which solution additive compounds are added, which serve to control the physical properties of the metals, wherein
- the solution is brought into contact with the treatment material and anodes;
- the solution situated in the vicinity of the anodes (anode space) and the solution situated in the vicinity of the treatment material (cathode space) are so separated from each other by ion-permeable means and/or the treatment solution is so guided in a deposition chamber that the solution situated in the vicinity of the anodes (anode space) and the solution situated in the vicinity of the treatment material (cathode space) do not mix; and
- the additive compounds, serving to control the physical properties of the metals, are added to the treatment solution at a location in the circuit from which, by means of flow, they can only pass into the cathode space,
- the quantity of the additive compounds, which corresponds to the concentration to be set in the treatment solution, being constantly added to the treatment solution, which contains no additive compounds and flows to the cathode space, and
- resultant decomposition products and unused additive compounds being removed, by means of filters, from the solution situated in the anode space and/or flowing away from the anode space and/or flowing away from the cathode space.

2. Method according to claim 1, characterised in that specific additives are added, by dosing, to the treatment solution supplied to the anode space, the residues of which additives, including decomposition products produced in the anode space, are filtered from the recycled solution in the circuit by means of filters specifically adapted to the constituent ingredients to be filtered-out.

3. Method according to one of claims 1 or 2, characterised in that the additive compounds are removed from the treatment solution, situated in a cathode current circuit connected to the cathode space, and from the treatment solution, situated in an anode current circuit connected to the anode space and separated from the cathode current circuit, by means of filters associated with the individual circuits.

4. Method according to one of the preceding claims, characterised in that the quantity of the additive compounds to be subsequently dosed is derived substantially from the volume of the circulated treatment solution as a result of a virtual lack of additive compounds in the treatment solution at the location where the compounds are added to the solution.

5. Method according to one of the preceding claims, characterised in that filters are used, which are selected from a group including wound candle filters, disc filters, pre-coat filters, gravity separators, activated charcoal filters, osmosis filters, molecular sieves and ion exchangers.

6. Method according to one of the preceding claims, characterised in that the solution is filtered initially in a first particle filter and thereafter by means of activated charcoal.

7. Method according to one of the preceding claims, characterised in that the treatment solution is guided in the circuit from the treatment material via filters to the anode and from there back again to the treatment material.

8. Method according to one of claims 1 to 6, characterised in that the solutions of the anode space and of the cathode space are guided and filtered in separate circuits.

9. Method according to one of the preceding claims, characterised in that, when insoluble anodes are used, a loss of metal ions in the treatment solution, caused by the electrolytic deposition of metal, is compensated-for by a chemical dissolution of metal parts by means of compounds of electrochemically reversible redox systems added to the treatment solution.

10. Method according to claim 9, characterised in that the metal parts situated in a separate regeneration chamber (10) have such a large effective surface that practically all of the metal-dissolving compounds of the redox system, which are supplied in the circuit to the regeneration chamber, are chemically reduced with a simultaneous dissolution of the metal parts.

## Revendications

1. Procédé destiné à déposer par électrolyse des métaux présentant des propriétés physiques déterminées sur la surface des produits à traiter à l'aide d'une solution de traitement mise en mouvement par un flux de liquide et acheminée dans un circuit, à laquelle on ajoute des composés additifs destinés à commander les propriétés physiques des métaux, dans lequel procédé
- la solution est mise en contact avec le produit à traiter et des anodes,
- la solution à proximité des anodes (zone des anodes) et la solution à proximité du produit à traiter (zone des cathodes) sont séparées l'une de l'autre par des moyens perméables aux ions et/ou la solution de traitement est acheminée dans une cellule de métallisation, de telle sorte que la solution à proximité des anodes (zone des anodes) et la solution à proximité du produit à traiter (zone des cathodes) ne peuvent pas se mélanger,
- les composés additifs de la solution de traitement, destinés à commander les propriétés physiques des métaux sont ajoutés dans une zone du circuit à partir de laquelle le flux ne peut les transporter que vers la zone des cathodes,
- les composés additifs étant ajoutés en continu à la solution de traitement, affluant vers la zone des cathodes et ne contenant pas de composés additifs, dans une quantité qui correspond à la concentration à réguler dans la solution de traitement, et
- les produits de dissolution obtenus et les composés additifs non utilisés sont éliminés à l'aide de filtres hors de la solution se trouvant dans la zone des anodes et/ou affluant hors de la zone des anodes et/ou hors de la zone des cathodes.

2. Procédé selon la revendication 1, caractérisé en ce que l'on ajoute à la solution de traitement acheminée vers la zone des anodes des additifs spéciaux, dont les résidus, ainsi que les produits de dissolution formés dans la zone des anodes sont évacués hors de la solution acheminée en retour dans le circuit, à l'aide de filtres spécialement adaptés aux composants à filtrer.

3. Procédé selon la revendication 1 ou 2, caractérisé en ce que les composés additifs sont évacués hors de la solution de traitement se trouvant dans un circuit de courant cathodique relié à la zone des cathodes et hors de la solution de traitement se trouvant dans un circuit de courant anodique relié à la zone des anodes et séparé du circuit de courant cathodique, à l'aide des filtres associés à chaque circuit séparé.

4. Procédé selon l'une quelconque des revendications précédentes, caractérisé en ce que la quantité de composés additifs à ajouter ultérieurement, suite à une très faible présence de composés additifs dans la solution de traitement, dans la zone où les composés sont ajoutés à la solution, est définie sensiblement par rapport au volume de la solution de traitement acheminée dans le circuit.

5. Procédé selon l'une quelconque des revendications précédentes, caractérisé en ce que l'on utilise des filtres issus d'un groupe comprenant des filtres enroulés en forme de bougie, des filtres rotatifs à disques, des filtres à couches, des séparateurs par gravité, des filtres à charbon actif, des filtres par osmose, des tamis moléculaires et des échangeurs d'ions.

6. Procédé selon l'une quelconque des revendications précédentes, caractérisé en ce que la solution est filtrée d'abord dans un premier filtre de particule ionique, et ensuite dans un filtre à charbon actif.

7. Procédé selon l'une quelconque des revendications précédentes, caractérisé en ce que la solution de traitement est acheminée dans un circuit depuis le produit à traiter vers les anodes en passant par des filtres, puis à partir des anodes à nouveau vers le produit à traiter.

8. Procédé selon l'une quelconque des revendications 1 à 6, caractérisé en ce que la solution dans la zone des anodes et la solution dans la zone des cathodes sont acheminées et filtrées dans des circuits séparés.

9. Procédé selon l'une quelconque des revendications précédentes, caractérisé en ce que, en cas d'utilisation d'anodes insolubles, une perte en ions métalliques dans la solution de traitement, due à la métallisation par électrolyse, est compensée par la dissolution chimique des particules métalliques à l'aide des composés des systèmes d'oxydoréduction, réversibles par voie électrochimique, des composés ajoutés à la solution de traitement.

10. Procédé selon la revendication 9, caractérisé en ce que les particules métalliques qui se trouvent dans une cellule de régénération (10) séparée présentent une surface, qui exerce une influence telle que pratiquement tous les composés du système d'oxydoréduction dissolvant le métal, acheminés dans le circuit vers la cellule de régénération, subissent une réduction chimique qui se produit en même temps que la dissolution des particules métalliques.
